Europäisches Patentamt

(19) European Patent Office

Office européen des brevets

(11) EP 0 697 967 B1

(12) **EUROPEAN PATENT SPECIFICATION**

(45) Date of publication and mention
of the grant of the patent:
**02.01.1997 Bulletin 1997/01**

(21) Application number: **94914386.1**

(22) Date of filing: **14.04.1994**

(51) Int. Cl.⁶: **B41M 5/40**, G03C 1/76,
G03F 7/11, G11B 7/24

(86) International application number:
**PCT/EP94/01182**

(87) International publication number:
**WO 94/26533 (24.11.1994 Gazette 1994/26)**

(54) **THERMOSENSITIVE RECORDING MATERIAL**

WARMEEMPFINDLICHES AUFZEICHNUNGSMATERIAL

SUPPORT D'ENREGISTREMENT THERMOSENSIBLE

(84) Designated Contracting States:
**BE DE FR GB NL**

(30) Priority: **12.05.1993 EP 93201366**

(43) Date of publication of application:
**28.02.1996 Bulletin 1996/09**

(73) Proprietor: **AGFA-GEVAERT
naamloze vennootschap
B-2640 Mortsel (BE)**

(72) Inventors:
• **DESIE, Guido Vital
B-2640 Mortsel (BE)**
• **LEENDERS, Luc Herwig
B-2640 Mortsel (BE)**

(56) References cited:
FR-A- 2 589 593          US-A- 2 140 089
US-A- 4 645 731

## Description

### 1. Field of the Invention.

The present invention relates to a dry imaging material, e.g., a DRAW (Direct Read After Write) or dry-processable (i.e., the latent image formed by exposure to radiation is made visible without the use of any liquid) recording element having high dimensional stability. The element comprises at least one supported recording layer and at least one barrier layer retarding the diffusion of water in liquid or vapour phase into the recording material.

### 2. Background of the Invention.

In several photographic fields the dimensional stability of the photographic material used for making the desired record is very important, and this applies to such photographic material both in unprocessed and processed state. Examples of applications where the importance of the dimensional stability is high are microphotography, astrophotography, aerophotography, photogrammetry, holography, recording of nucleophysical phenomena. Examples of fields of application, where the requirements for dimensional stability of the material are very stringent, are e.g. the preparation of lithographic offset printing forms and the preparation of masks for use in the production of microelectronic integrated circuits or printed circuit boards (PCB).

Mask for use in the production of microelectronic integrated circuits has, in the context of this invention, to be understood as an "irradiation mask" and not as the "lithographic mask". The difference between these two masks is disclosed in FR 2,589,593 in figure 2 and from line 30 on page 9 to line 15 on page 10. The FR-patent, referred to, is itself concerned with a "lithographic mask" and the $SiO_x$ is part of that lithographic mask.

A dimensionally stable image recording material is a material that is quite unsensitive to changes in relative humidity (RH), i.e. a material that, when bringing it from an ambient condition with one relative humidity to an ambient condition with another relative humidity, keeps the same dimensions.

In a process for preparing lithographic offset printing forms or in a process for preparing masks for use in the production of microelectronic integrated circuits or printed circuit boards (PCB), high dimensional stability can be achieved by using a dry imaging material. Such imaging material is e.g. a heat-mode recording material comprising a heat-mode recording layer, i.e. a layer wherein the recording proceeds by absorption of light causing an intense heating that results directly in a human readable or machine readable mark. Another dry imaging material may be called a printout or direct photo-mode recording material, where the basic recording process implies photochemical reactions. Examples of such photo-mode recording materials are photochromic materials as described e.g. by K.I. Jacobson and R.

E. Jacobson in "Imaging Systems", Focal press (1976) chapter 8, p. 143 and seq..

In common heat-mode recording materials a thin recording layer of relatively low melting metals, their alloys or dyes are present on a support. Such layers are strictly not light-sensitive but are responsive to the thermal energy set free by the absorption of a high-intensity, short-duration pulse of laser light. The writing spot ablates or melts the thermo-sensitive layer that in the heated area by surface tension contracts and shows a small cavitation or hole.

When such a heat-mode recording layer is supported by a polyester resin film, especially polyethylene terephthalate film, a recording element with high dimensional stability may be achieved.

It has been found however that even such a material suffers from dimensional changes as a function of changing relative humidity. Although the dimensional change in an equilibrium state is only in the order of $8\mu m/m/\%$ RH, the rate of change of the dimensions when bringing the material from an ambient condition with one relative humidity to an ambient condition with different relative humidity is still high, which brings about that relatively high dimensional changes may take place in the first few hours after making the image. It is desired that the speed of dimensional change is slow enough compared with the normal working habits. Since a typical PCB production can be finished in about 4 h, the rate of dimensional change, as a consequence of changing relative humidity, has to be very low during the first hours of usage.

Even when containing an already fairly dimensionally stable polyester support, it is desirable that a dry processable or DRAW recording material for use e.g. in PCB production, has a still lower rate of change of dimensions.

### 3. Object and Summary of the Invention.

It is an object of the present invention to provide a dry imaging material, e.g. a DRAW (Direct Read After Write) or a dry processable recording element, comprising a supported recording layer of which the rate of dimensional change as a function of changing relative humidity (RH) is very low.

It is a particular object of the invention to provide a dry imaging material, e.g. a DRAW (Direct Read After Write) or dry processable recording element, comprising a recording layer and a resin support in which the dimensional changes as a function of the change of the relative humidity of the environment in the first 3 to 4 hours after the occurrence of the RH-change are less than for pure polyethylene terephthalate (PET) film alone.

Further objects and advantages of the invention will become clear from the further description.

According to the present invention a dry imaging material is provided, comprising a support, an image recording layer and at least one barrier layer substantially retarding the diffusion of water in liquid or vapour phase into the recording element, characterized in that said barrier layer is a vapour-deposited metal oxide layer.

In a preferred embodiment of the present invention a dry imaging material, as defined above, is provided, wherein said vapour-deposited metal oxide layer is substantially composed of $SiO_x$, x standing for a value ranging from 1.2 to 1.8 and the thickness of said vapour-deposited metal oxide layer ranges from 10 to 150 nm.

## 4. Detailed Description of the Invention.

### The Barrier layer.

Suitable barrier layers are thin layers of single metal oxides or mixtures of several metaloxides, e.g. oxides of Mg, Al, Sn, Zn, Fe, Ba or Si. These oxide layers may be applied by sputtering as described in e.g. Japanese non examined application JP 02/122,924, by vacuum vapour deposition as described in e.g. UK Patent Application N° 2,211,516, by electron beam evaporation as described in e.g. UK Patent Application N° 2,074,345, Chemical Vapour Deposition (CVD) or Plasma Enhanced CVD as described in e.g. EP-A 299754.

The barrier layer in the Direct Read After Write (DRAW) or dry processable recording element according to this invention, comprising a metal oxide, can be vapour-deposited according to the processes described in i.a. UK Patent Application N° 2,211,516 and the paper "Transparent Barriers for Foodpacking" presented by T. Krug and K. Rübsam (LEYBOLD AG, Hanau, Federal Republic of Germany) on SVC-Conference New Orleans, April 29 to May 4, 1990, is used.

In general, the vapour-deposited metal-oxide layer has a thickness ranging from 10 to 200 nm, preferably from 50 to 150 nm. Thickness values above 200 nm do not result in further improvement of the dimensional stability.

In a preferred embodiment of the invention the barrier layer comprises $SiO_x$ as the metal oxide. The $SiO_x$ can be vapour-deposited e.g. by thermal evaporation, electron beam gun evaporation, or sputtering of Si or of SiO (silicon monoxide) wherein x is 1 ( x has a value of 2 in $SiO_2$ ). The evaporation temperature is about 1350°C.

The vapour of SiO is oxidized in a controlled reactive atmosphere to achieve at the vapour-deposited glass layer a degree of oxidation ranging from 1.2 to 1.8. In other words, x stands for a value ranging from 1.2 to 1.8. According to this invention, the x in $SiO_x$, preferably is between 1.5 and 1.7, which assures the best compromise between transparency and non-water permeability.

Physically the vapour-deposited $SiO_x$ layer consists of a mixture of SiO, $Si_2O_3$, and $SiO_2$. The $SiO_x$ layer is chemically inert and protects the polyester film support from absorbing water vapour from the atmosphere or other water vapour sources.

The thickness of the vapour-deposited $SiO_x$ layer should not be lower than 10 nm, since otherwise insufficient improvement of the dimensional stability is achieved.

A barrier layer as described above can be deposited on many types of organic resin film supports, e.g. a polyester, a polycarbonate, a polyamide, a styrene polymer or copolymer and a (meth)acrylate polymer or copolymer. For high dimensional stability in the recording element according to the present invention the barrier layer is preferably deposited on a polyester film.

One or both sides of the support, e.g. polyester film support, can be provided with a vapour-deposited barrier layer and in case the polyester film support is provided according to a preferred embodiment on both sides with a vapour-deposited barrier layer, the barrier layers need not have the same thickness.

Polyester film supports that can be covered advantageously with a vapour-deposited barrier layer according to the present invention are films of polyesters of alkylene glycol and/or glycerol with terephthalic, isophthalic, adipic, maleic, fumaric and/or azelaic acid. Polyethylene terephthalate is the most preferred polyester film support for use according to the present invention.

The support, having a vapour-deposited barrier layer on one or both sides according to this invention, can be used as a support for a DRAW or dry processable image recording layer. The image recording layer can be coated on the support side opposing the barrier layer, when only one barrier layer is present or can be coated on top of a barrier layer, when two barrier layers are present. When the support coated with vapour-deposited barrier layer, according to this invention, is used as the support for the image recording layer, the thickness of the support coated with vapour-deposited barrier layer, ranges preferably from 50 to 300 $\mu m$.

The support, coated with vapour-deposited barrier layer on one or both sides according to this invention, can be coated on one side, preferably the side opposite to the barrier layer, with an adhesive layer and can then be used to be laminated on top of an image recording layer to protect the image recording layer. When the support coated with vapour-deposited barrier layer, according to this invention, is used to cover an image recording layer, the thickness of the support coated with vapour-deposited barrier layer, ranges preferably from 2 to 50 $\mu m$.

When the barrier layer is an outermost layer in the recording element according to this invention, it may be necessary to improve the mechanical strength of said barrier layer by covering said barrier layer by a protective layer. A preferred protective layer is a protective layer substantially composed of $SiO_x$, x standing for a value ranging from 1.8 to 2.

### The image recording layer.

According to one embodiment the image recording layer in the recording element according to the present invention is a photodelamination layer as described in Research Disclosure (RD) Item 22202 (Oct. 1982), p328-329.

According to another embodiment the image recording layer is a photochromic layer as described in Chapter 8 of K.I. Jacobson and R. E. Jacobson, Imaging Systems, Focal press (1976) p. 143 et seq.

According to a preferred embodiment the image recording layer is a heat-mode recording layer. Imaging elements comprising a heat-mode recording layer, as described e.g. in European non published application 93200342.9, can advantageously be used for making a lithographic plate for use in lithographic printing. Said heat-mode recording layer can be composed of different materials. Tellurium and tellurium alloys have been used widely to form highly reflective thin metal films wherein heating with laser beam locally reduces reflectivity by pit formation (ref. e.g. the periodical Physik in unserer Zeit, 15. Jahrg. 1984/Nr. 5, 129-130 the article "Optische Datenspeicher" by Jochen Fricke). Tellurium is toxic and has poor archival properties because of its sensitivity to oxygen and humidity. Therefore, the recording layers containing tellurium are airtightly protected to achieve an acceptable archival life.

To avoid the toxicity problem other relatively low melting metals such as Sn and Bi have been introduced in the production of a heat-mode recording layer. A survey of other metals also suited for use in DRAW heat-ode recording and suitable for use according to the present invention, is given in US-P 4,499,178 and 4,388,400.

Metal layers have a relatively high reflectivity so that by their ablation in heat-mode recording spots of lower reflectivity are obtained.

According to another embodiment an increase in transmission is obtained in laser beam heated areas by using an initially poor reflective heat-mode recording layer on a transparent support which layer becomes ablated in the laser beam struck areas. Such layer intended for COM-production and being made of co-deposited low melting point metals and sulphides such as GeS or SnS on a transparent support is described e.g. in Journal of Applied Photographic Engineering, Vol. 9, No. 1, Feb. 1983, p. 12. For the production of optical disks wherein the information is read in the reflection mode said poor reflective heat-mode recording layer is applied onto a relatively high melting reflective support or layer, e.g. aluminium layer, carried by a support.

In a further embodiment heat-mode recording is carried out with binderless organic dye layers as described e.g. in the periodical Philips Techn. T. 41, p. 338-346 by D. J. Gravesteijn and J. van der Veen.

Thin (normally less than 1 $\mu$m thick) layers of metals, alloys or dyes suited for heat-mode recording are produced advantageously by vacuum-deposition.

In a preferred embodiment of this invention a thin vacuum deposited layer of Bi is used as the heat-mode recording layer because of its low toxicity and while it requires little energy for ablating by fusion or evaporation and forms films with ease by vapour deposition under vacuum conditions.

The thickness of the metal layer is preferably not larger than 700 nm and more preferably in the range of 50 to 600 nm.

The ablatable metal layer is applied preferably by vapour deposition under vacuum. For example, the coating of a bismuth layer by vapour deposition proceeds under reduced pressure in the range of $10^{-2}$ Pa to $8 \times 10^{-1}$ Pa as described in published European patent application No. 0 384 041.

The ablatable metal layer may be applied together with or may be coated with substances for increasing the recording sensitivity, e.g. substances that lower the light-reflectivity and improve the absorption of laser light. Examples of such substances are the metal oxides, sulfides and halides described e.g.in UK Patent application 2 036 597. GeS and SnS are preferred for said purpose and may be applied in a thickness depending on the wavelength of the recording light, e.g. in the range of 5 to 100 nm, as antireflection layer not disturbing the ablation of the ablatable metal layer.

The support for the thin metal layers according to this invention may be chosen out of many types of organic resin film supports, e.g. a polyester, a polycarbonate, a polyamide, a styrene polymer or copolymer and a (meth)acrylate polymer or copolymer. According to this invention, however it is especially interesting that the support for the thin metal layer be a polyester film, an especially suitable support for the thin metal layer according to this invention is polyethylene terephthalate film. The thickness of the support can range between 2 and 300 $\mu$m.

The support for the thin metal layer can, according to this invention, be the above mentioned resin film coated with a barrier layer and the thin metal layer may be coated or vapour deposited on top of the barrier layer or on the support side opposite to the barrier layer. When the resin film coated with a barrier layer, asmentioned above, is coated on both sides with a barrier layer and is used as support for the thin metal layer, the thin metal layer is coated on top of said barrier layer.

To seal completely the Direct Read After Write (DRAW) or dry processable recording element from moisture, the thin vacuum-deposited metal layer, supported by a resin film coated on one or both sides with a barrier layer, can be covered with a second organic resin that has been coated with said barrier layer, by a method according to US-P 5,147,490 that is incorporated herein by reference.

A Direct Read After Write (DRAW) or dry processable recording element, according to the present invention, may advantageously be used in any application where dimensional stability of the recording material is of great importance.

A Direct Read After Write (DRAW) or dry processable recording element, according to the present invention, is especially advantageous in the preparation of master masks for the production of printed circuit boards (PCB).

It is also useful advantageous to use a Direct Read After Write (DRAW) or dry processable recording element, according to the present invention, in the preparation of lithographic printing plates.

EXAMPLE 1.

On both sides of a 100 μm thick polyethylene terephthalate (PET) film (12), an 50 nm thick $SiO_x$ layer, with x=1.5, was vapour-deposited. On top of one of the $SiO_x$ layers, a 230 nm thick layer of Bi (13) was vapour deposited. This gives composite element 1. On one side of another PET-film, 12 μm thick, a 50 nm thick $SiO_x$ layer, with x=1.5, was vapour-deposited, while on the other side of the PET-film 12' an adhesive layer, consisting of a co(butylacrylate-vinylacetate) adhesive was coated (composite element 2). Composite element 2 was then laminated on top of the Bi-layer of composite element 1, according to the method described in US-P 5,147,490 so as to make a heat-mode recording element (HMR 1).

EXAMPLE 2

On one side of a 175 μm thick PET-film (22) a 110 nm thick $SiO_x$ layer, with x=1.5, was vapour-deposited, and on the other side of the PET-film a Bi-layer was vapour-deposited. This gives composite element 3. On one side of another PET-film, 12 μm thick, a 50 nm thick $SiO_x$ layer, with x=1.5, was vapour-deposited, while on the other side of PET-film an adhesive layer, consisting of a co(butylacrylate-vinylacetate) adhesive was coated (composite element 4). Composite element 4 was then laminated on top of the Bi-layer of composite element 3, according to the method described in US-P 5,147,490 so as to make a heat-mode recording element (HMR 2).

EXAMPLE 3

On one side of a 100 μm thick PET-film a Bi-layer was vapour-deposited to a thickness of 110 nm. This gives composite element 5. On one side of an other PET-film, 12 μm thick, a 50 nm thick $SiO_x$ layer, with x=1.5, was vapour-deposited, while on the other side of PET-film an adhesive layer, consisting of a co(butylacrylate-vinylacetate) adhesive was coated (composite element 6). Composite element 6 was laminated on top of the Bi-layer of composite element 5 and on the side opposite of the Bi-layer of composite element 5, according to the method described in US-P 5,147,490 so as to make a heat-mode recording element (HMR 3).

COMPARATIVE EXAMPLE 1.

The procedure of example 2 was repeated, except that no $SiO_x$ layer was present. On a 175 μm thick PET film a Bi-layer was vacuum deposited (composite element 7). Another PET film, 12 μm thick was coated on one side with an adhesive layer consisting of a co(butylacrylate-vinylacetate) adhesive (composite element 8). Composite element 8 was laminated on top of the Bi-layer of composite element 7 so as to give a heat-mode recording element (HRM4).

The dimensional change of the heat-recording materials (HMR 1, HMR 2, HMR 3, HMR 4 and pure 175 μm and 100 μm thick PET film as a function of time was measured when the RH was changed from about 30 % to about 60 % RH, the RH-change (b % RH) was accurately measured.

The dimensional changes were measured with induction distance sensor in an apparatus sold by TESA S.A. CH1020 Switzerland under the commercial name of DUOTAST and TESAMATIC N.

The dimensional change (a μm) of a 200 mm long and 34 mm broad sample was measured every minute. The measurement proceeded in the longitudinal direction of the sample. The dimensional change ( a μm) was normalized to a length of 1 m and to a change in relative humidity (RH) of 1 %. The result (c) is thus expressed in μm/m . % RH :

$$c = \frac{a \ \mu m}{0.20 \ m \ x \ b \ \% \ RH}$$

The dimensional change was measured in μm/m x %RH and followed for several hours. It became clear that the dimensional change within the first 4 hours of RH-change is smallest with the 3 image recording elements according to this invention (HRM1, HRM2 and HRM3).

**Claims**

1. A dry imaging material comprising a support, an image recording layer and at least one outermost barrier layer substantially retarding the diffusion of water in liquid or vapour phase into the recording element, characterized in that said barrier layer is a vapour-deposited layer of at least one metal oxide.

2. A dry imaging material according to claim 1, wherein said support is situated between said vapour-deposited metal oxide layer-and said image recording layer.

3. A dry imaging material according to claim 1 or 2, wherein said recording element comprises following layers in consecutive order : (i) a vapour-deposited metal oxide layer, (ii) a support, (iii) an image recording layer, (iv) an adhesive layer, (v) a support, (vi) a vapour-deposited metal oxide layer.

4. A dry imaging material according to claims 1 to 3, wherein the thickness of said vapour-deposited metal oxide layer or layers ranges from 10 to 150 nm.

5. A dry imaging material according to claims 1 to 4, wherein said vapour-deposited metal oxide layer is a vapour-deposited glass layer having a thickness of at least 10 nm and is substantially composed of $SiO_x$, x standing for a value ranging from 1.2 to 1.8.

6. A dry imaging material according to claim 5, wherein x stands for a value ranging from 1.5 to 1.7.

7. A dry imaging material according to claims 1 to 4, wherein said vapour-deposited metal oxide layer is substantially composed of $Al_2O_3$.

8. A dry imaging material according to claims 1 to 7, wherein said vapour-deposited metal oxide layer is protected by a protective layer substantially composed of $SiO_x$, x standing for a value ranging from 1.8 to 2.

9. A dry imaging material according to claims 1 to 8, wherein said support consists essentially of polyethyleneterephthalate.

10. A dry imaging material to any of the claims 1 to 9, wherein said image recording layer is a heat mode image recording layer.

11. A dry imaging material according to claim 10, wherein said heat mode image recording layer is vacuum deposited on said support.

12. A dry imaging material according to claim 10 or 11, wherein said heat mode image recording layer is a vacuum deposited bismuth layer.

## Patentansprüche

1. Ein trockenes Bildaufzeichnungsmaterial mit einem Träger, einer Bildaufzeichnungsschicht und wenigstens einer Außensperrschicht, die die Diffusion von Wasser in Flüssigphase oder Gasphase in das Aufzeichnungselement wesentlich verzögert, dadurch gekennzeichnet, daß die Sperrschicht eine aufgedampfte aus wenigstens einem Metalloxid zusammengesetzte Schicht ist.

2. Ein trockenes Bildaufzeichnungsmaterial nach Anspruch 1, dadurch gekennzeichnet, daß sich der Träger zwischen der aufgedampften Metalloxidschicht und der Bildaufzeichnungsschicht befindet.

3. Ein trockenes Bildaufzeichnungsmaterial nach Anspruch 1 oder 2, dadurch gekennzeichnet, daß das Aufzeichnungselement der angegebenen Reihe nach die folgenden Schichten enthält : (i) eine aufgedampfte Metalloxidschicht, (ii) einen Träger, (iii) eine Bildaufzeichnungsschicht, (iv) eine Klebeschicht, (v) einen Träger und (vi) eine aufgedampfte Metalloxidschicht.

4. Ein trockenes Bildaufzeichnungsmaterial nach Anspruch 1 bis 3, dadurch gekennzeichnet, daß die Stärke der aufgedampften Metalloxidschicht(en) zwischen 10 und 150 nm liegt.

5. Ein trockenes Bildaufzeichnungsmaterial nach Anspruch 1 bis 4, dadurch gekennzeichnet, daß die aufgedampfte Metalloxidschicht eine aufgedampfte Glasschicht mit einer Stärke von wenigstens 10 nm ist und wesentlich aus $SiO_x$ zusammengesetzt ist, wobei x einen Wert zwischen 1,2 und 1,8 bedeutet.

6. Ein trockenes Bildaufzeichnungsmaterial nach Anspruch 5, dadurch gekennzeichnet, daß x einen Wert zwischen 1,5 und 1,7 bedeutet.

7. Ein trockenes Bildaufzeichnungsmaterial nach Anspruch 1 bis 4, dadurch gekennzeichnet, daß die aufgedampfte Metalloxidschicht wesentlich aus $Al_2O_3$ zusammengesetzt ist.

8. Ein trockenes Bildaufzeichnungsmaterial nach Anspruch 1 bis 7, dadurch gekennzeichnet, daß die aufgedampfte Metalloxidschicht durch eine wesentlich aus $SiO_x$ zusammengesetzte Schutzschicht geschützt wird, wobei x einen Wert zwischen 1,8 und 2 bedeutet.

9. Ein trockenes Bildaufzeichnungsmaterial nach Anspruch 1 bis 8, dadurch gekennzeichnet, daß der Träger wesentlich aus Polyethylenterephthalat zusammengesetzt ist.

10. Ein trockenes Bildaufzeichnungsmaterial nach irgendeinem der Ansprüche 1 bis 9, dadurch gekennzeichnet, daß die Bildaufzeichnungsschicht eine wärmeempfindliche Bildaufzeichnungsschicht ist.

11. Ein trockenes Bildaufzeichnungsmaterial nach Anspruch 10, dadurch gekennzeichnet, daß die wärmeempfindliche Bildaufzeichnungsschicht auf den Träger aufgedampft wird.

12. Ein trockenes Bildaufzeichnungsmaterial nach Anspruch 10 oder 11, dadurch gekennzeichnet, daß die wärmeempfindliche Bildaufzeichnungsschicht eine aufgedampfte Bismutschicht ist.

## Revendications

1. Matériau de formation d'image à sec, comprenant un support, une couche d'enregistrement d'image et au moins une couche d'arrêt la plus à l'extérieur retardant essentiellement la diffusion de l'eau en phase liquide ou en phase vapeur dans l'élément d'enregistrement, caractérisé en ce que ladite couche d'arrêt est une couche d'au moins un oxyde métallique, déposée à partir de sa phase vapeur.

**2.** Matériau de formation d'image à sec selon la revendication 1, dans lequel ledit support est situé entre ladite couche d'oxyde métallique déposée à partir de sa phase vapeur et ladite couche d'enregistrement d'image.

**3.** Matériau de formation d'image à sec selon la revendication 1 ou 2, dans lequel ledit élément d'enregistrement comprend les couches ci-après dans l'ordre successif: (i) une couche d'oxyde métallique déposée à partir de sa phase vapeur, (ii) un support, (iii) une couche d'enregistrement d'image, (iv) une couche adhésive, (v) un support, (vi) une couche d'oxyde métallique déposée à partir de sa phase vapeur.

**4.** Matériau de formation d'image à sec selon les revendications 1 à 3, dans lequel l'épaisseur de la ou desdites couches d'oxyde métallique déposées à partir de leur phase vapeur se situe dans le domaine de 10 à 150 nm.

**5.** Matériau de formation d'image à sec selon les revendications 1 à 4, dans lequel ladite couche d'oxyde métallique déposée à partir de sa phase vapeur est une couche en verre déposée à partir de sa phase vapeur, possédant une épaisseur d'au moins 10 nm et composée essentiellement de $SiO_x$, x représentant une valeur se situant dans le domaine de 1,2 à 1,8.

**6.** Matériau de formation d'image à sec selon la revendication 5, dans lequel x représente une valeur se situant dans le domaine de 1,5 à 1,7.

**7.** Matériau de formation d'image à sec selon les revendications 1 à 4, dans lequel ladite couche d'oxyde métallique déposée à partir de sa phase vapeur est composée essentiellement de $Al_2O_3$.

**8.** Matériau de formation d'image à sec selon les revendications 1 à 7, dans lequel ladite couche d'oxyde métallique déposée à partir de sa phase vapeur est protégée par une couche de protection composée essentiellement de $SiO_x$, x représentant une valeur se situant dans le domaine de 1,8 à 2.

**9.** Matériau de formation d'image à sec selon les revendications 1 à 8, dans lequel ledit support est constitué essentiellement de polyéthylène-téréphtalate.

**10.** Matériau de formation d'image à sec selon l'une quelconque des revendications 1 à 9, dans lequel ladite couche d'enregistrement d'image est une couche d'enregistrement d'image thermosensible.

**11.** Matériau de formation d'image à sec selon la revendication 10, dans lequel ladite couche d'enregistrement d'image thermosensible est déposée par vaporisation sous vide sur ledit support.

**12.** Matériau de formation d'image à sec selon la revendication 10 ou 11, dans lequel ladite couche d'enregistrement d'image thermosensible est une couche de bismuth déposée par vaporisation sous vide.